# EUROPEAN PATENT SPECIFICATION

(11) **EP 0 664 618 B1**
(45) Date of publication and mention of the grant of the patent: **29.07.1998**
(21) Application number: 93119705.7
(22) Date of filing: 07.12.1993
(51) Int. Cl.: H03L 7/23

(54) **Local oscillation frequency synthesizer**
Frequenzsynthetisierer für die Erzeugung einer Überlagerungsfrequenz
Synthétiseur de fréquence produisant une oscillation locale

(43) Date of publication of application: 26.07.1995
(73) Proprietor: NEC CORPORATION, Tokyo (JP)
(72) Inventor: Jokura, Jun, c/o NEC Corporation, Tokyo (JP)
(74) Representative: VOSSIUS & PARTNER

(56) References cited:
- US-A- 4 940 950
- PATENT ABSTRACTS OF JAPAN vol. 10, no. 129 (E-403) 14 May 1986 & JP-A-60 261 220 (MATSUSHITA DENKI SANGYO KK) 24 December 1985

## Description

This invention relates to a local oscillation synthesizer , and more particularly to the high speed change-over of a frequency in a local oscillation frequency synthesizer.

A conventional local oscillation frequency synthesizer comprises a reference frequency generator for generating a reference frequency, a voltage controlled oscillator for generating a frequency dependent on a voltage applied thereto, a frequency divider for dividing the frequency of the voltage controlled oscillator by a predetermined number, a phase comparator for comparing phases of the reference frequency and the divided frequency, a charge pump for generating first and second voltages dependent on a phase difference in the phase comparator, and a loop filter for applying an integrated value of the first and second voltages to the voltage controlled oscillator.

In operation, the reference frequency generator generates a reference frequency suited for a selected channel, and the reference frequency and a divided frequency supplied from the frequency division circuit are compared in phase by the phase comparator, so that a phase difference signal is generated therein.

Then, the charge pump generates a voltage dependent on the phase difference signal, and the voltage is integrated in the loop filter, so that an integrated voltage is applied to the voltage controlled oscillator, from which a frequency dependent on the integrated voltage is supplied to the frequency division circuit. Consequently, a controlled carrier frequency is obtained in the voltage controlled oscillator.

In this conventional local oscillation synthesizer, capacitors are connected to outputs of the phase comaprator to result in the expansion of the dead zone for phase comparison thereby improving a C/N value. In other words, a carrier frequency is changed in high speed, in the case where a gain of the loop system is high. For this purpose the consideration should be made in regard to parameters such as a frequency division ration, a property of the loop filter, etc. When the gain is heightened in accordance with the property of the loop filter, a noise band becomes wide, so that the sensitivity of the phase difference signal becomes high, while noise tends to be introduced into the loop system to result in the deterioration of a c/N value, conventionally, which is overcome by the provision of the aforementioned capacitors.

In the conventional local oscillation synthesizer, however, there is a disadvantage in that a carrier frequency is fluctuated up and down to result in the tailing of vibrations in the vicinity of a converging value, because the dead zone for phase comparison is expanded, although there is an advantage in that the change of a frequency is fast in accordance with the high gain of the loop system, when channels are changed-over.

JP-A-60-261220 discloses a synthesizer oscillator which realises a high resolution by a response of high speed and realises a wide frequency variation wits by providing first and second PLL synthesizer oscillators, an arithmetic unit, and mixer for synthesizing output of both oscillators. The second PLL has parameter such as reference frequency, different from that of the first PLL, and the output of the second PLL is subjected from the output of the first PLL, since the resolution of the first PLL is limited.

US-A-4,940,950 discloses a frequency synthesizer system using approximation to provide closely spaced discrete frequencies over a wide range with rapid acquisition. The phase locked-loops of said system provide an output frequency with resolution less than the reference frequencies due to the application of unique direct synthesis method. Additional resolution and correction of error due to the approximations is obtained by slightly varying the frequency of the master reference frequency.

The "C/N ratio (carrier to noise ratio)" is defined by a value in which a transmission carrier wave power C is divided by a noise density of channel P_{N}/B (=kT) in a communication channel. The information transmission capacity of the channel is expressed by 3 log₂ (1+C/kT) and influenced by the C/N ratio. When the noise is impulse noise, the magnitude is expressed by a peak value.

Accordingly, it is an object of the invention to provide a local oscillation frequency synthesizer in which vibration is small in the vicinity of a frequency converging value in changing-over a frequency, even in the case where dead zone for phase comparison is expanded to improve a c/N value of an output signal.

It is a further object of the invention to provide a local oscillation frequency synthesizer in which a system gain is set to be high.

It is a still further object of the invention to provide a local oscillation frequency synthesizer in which a frequency is stably changed over with high speed.

These objects are solved with the features of the claims.

The invention will be explained in more detail in conjunction with appended drawings, wherein:
Fig. 1 is a block diagram showing a conventional local oscillation frequency synthesizer,
Fig. 2 is a block diagram showing a local oscillation frequency synthesizer in a preferred embodiment according to the invention,
Fig. 3 is a block diagram showing the flow of control signals in the preferred embodiment, and
Fig. 4 is a waveform diagram showing the changed of oscillation frequencies in the preferred embodiment.

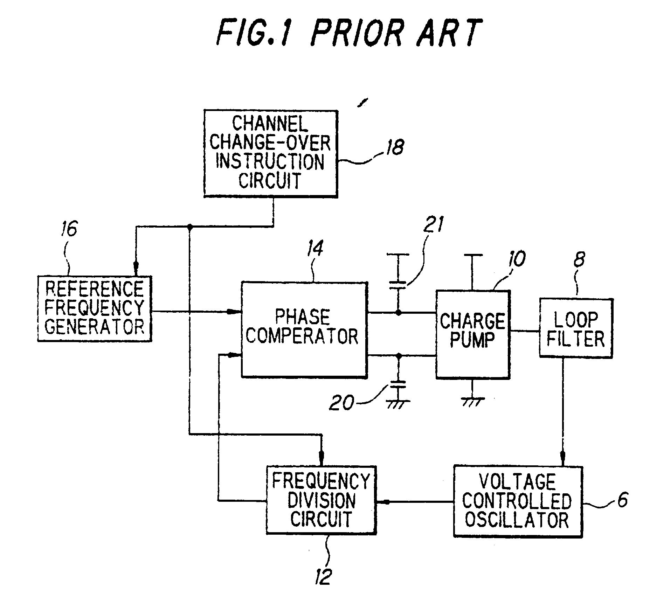

Before explaining a local oscillation frequency synthesizer in the preferred embodiment, the aforementioned conventional local oscillation frequency synthesizer will be explained in Fig. 1.

In the conventional local oscillation frequency synthesizer as shown in Fig. 1, a reference frequency from a reference frequency generator 16 and a frequency-divided signal from a frequency division circuit 12 are supplied to a phase comparator 14, in which the comparison of phases is carried out to provide a phase difference signal to be supplied to a charge pump 10.

Then, the charge pump 10 is driven to supply a controlled voltage dependent on the phase difference signal via a loop filter 8 to a voltage controlled cscillator 6, in which a carrier frequency is generated dependent on the controlled voltage. The carrier frequency is divided in the frequency division signal supplied from a channel change-over instruction circuit 18. The division signal is also utilized as a channel signal to be supplied to the reference frequency generator 16.

In this conventional local oscillation frequency synthesizer, a gain of the loop is required to be high to change-over frequencies with high speed.

For this purpose, the frequency division ratio and a property of the loop filter 8 must be considered. In the case where the loop filter 8 is changed in property, a noise band width becomes wide to increase the sensitivity of the phase difference signal, while noise becomes easy to be introduced into the system to deteriorate a C/N value of an oscillation output. In consideration of this disadvantage, capacitors 20 and 21 are provided at the outputs of the phase comparator 14 to expand a dead zone, that is, a band for no sensitivity, thereby improving a C/N value. In practical, however, this is a negative measure.

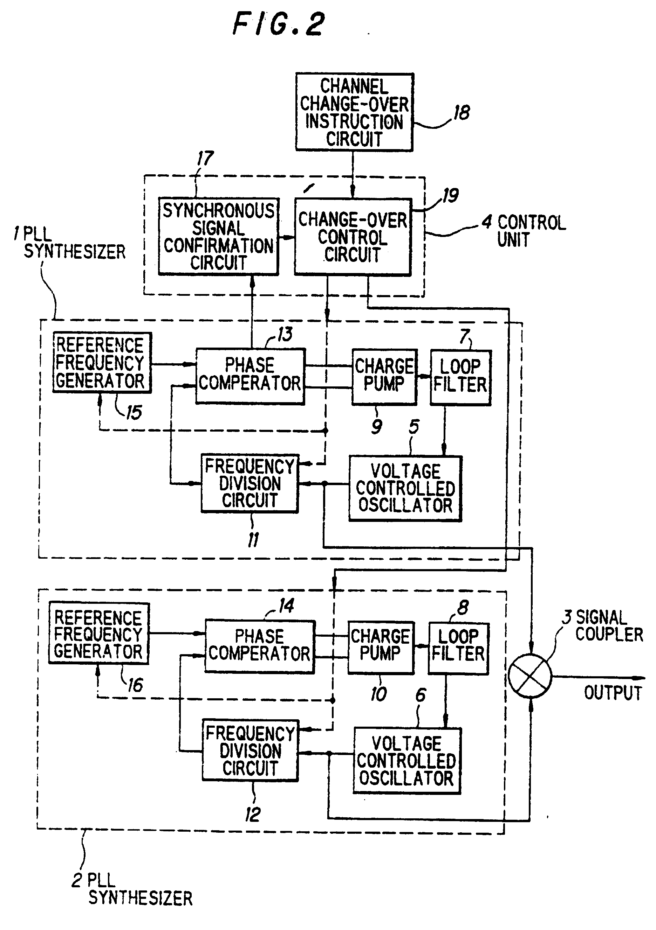

Next, a local oscillation frequency synthesizer in the preferred embodiment will be explained in Fig. 2.

The local oscillation frequency synthesizer comprises a phase locked loop (PLL) synthesizer units 1 and 2, a signal coupler 3 for combining signals supplied from the PLL synthesizer units 1 and 2, a control unit 4 for controlling the PLL synthesizer units 1 and 2, and a channel change-over instruction circuit 18.

The PLL synthesizer unit 1 comprises a voltage controlled oscillator 5, a loop filter 7, a charge pump 9, a frequency division circuit 11, a phase comparator 13, and a reference frequency generator 15. The PLL synthesizer unit 2 comprises a voltage controller 6, a loop filter 8, a charge pump 10, a frequency division circuit 12, a phase comparator 14, and a reference frequency generator 15, and the control unit 4 comprises a synchronous signal confirmation circuit 17 and a change over control circuit 19.

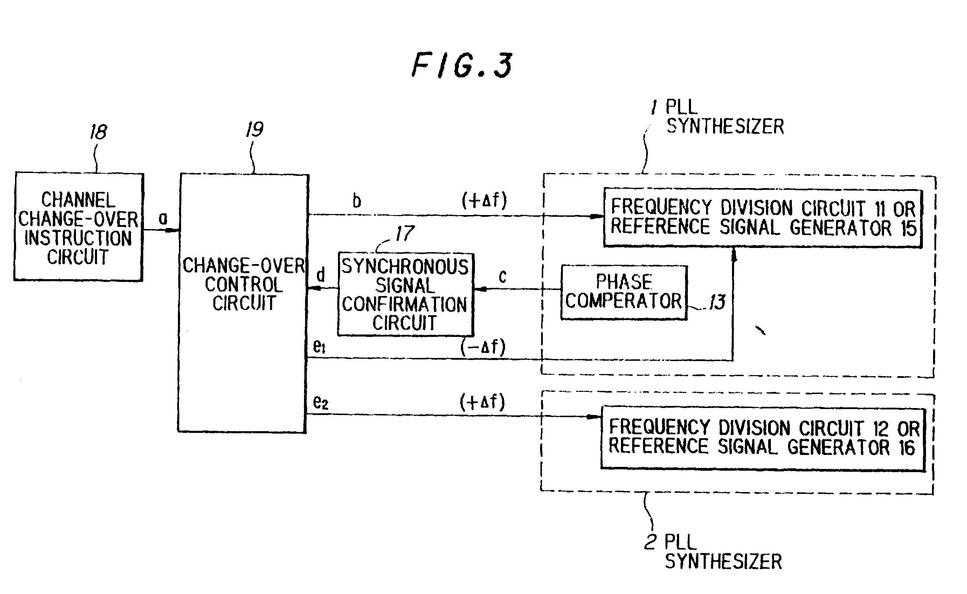

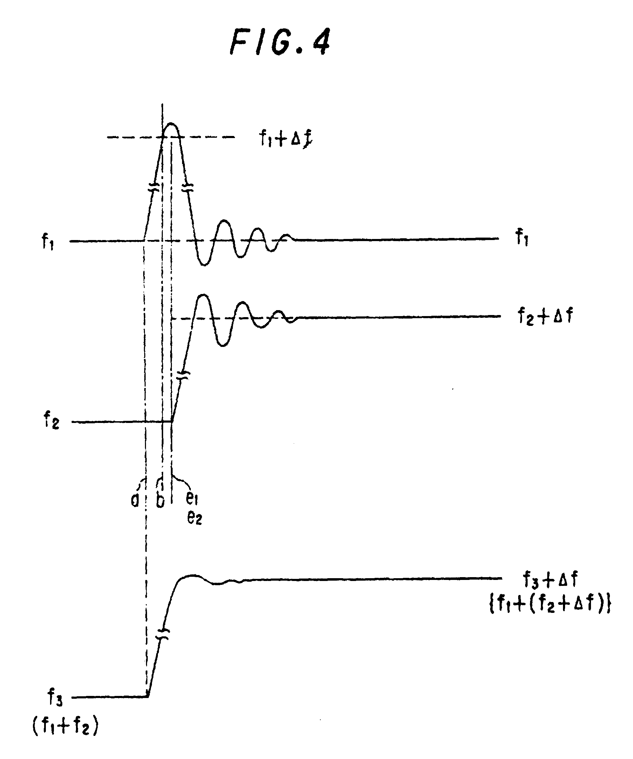

In operation, a channel change-over signal a (Figs. 3 and 4) is generated in the channel change-over instruction circuit 18, so that the change-over signal a is supplied to the change-over control circuit 19, from which a control signal b (Figs. 3 and 4) is supplied to the PLL synthesizer units 1 and 2. Thus, a carrier frequency f₁ is increased in the PLL synthesizer unit 1 by Δf. Then, when the phase is pulled into a predetermined phase, the phase comparator 13 generates a synchronous signal c (Fig. 3) to be supplied to the synchronous signal confirmation circuit 17, in which it is confirmed that a carrier frequency is coarsely adjusted to be "f₁ + Δf" so that a confirmation signal d (Fig. 3) is supplied therefrom to the change over control circuit 19. Then, the change-over control circuit 19 supplies the PLL synthesizer units 1 and 2 with control signals e₁ and e₂ (Figs. 3 and 4), by which a carrier frequency "f₁ + Δf" is decreased in the PLL synthesizer unit 1 to be "f₁" by Δf, while a carrier frequency f₂ is increased in the PLL synthesizer unit 2 to be "f₂ + Δf" by Δf.

Consequently, the carrier frequency f₁ from the PLL synthesizer unit 1 and the carrier frequency "f₂ + Δf" from the PLL synthesizer unit 2 are combined in the signal coupler 3 to provide a carrier frequency "f₃ + Δf" ( f₃ =f₁ + f₂) as shown in Fig. 4. In this manner, the channel synchronism is set up.

As clearly seen in Fig. 4, vibrations of the signals "f₁" and "f₂ + Δf" have symmetrical modes in the vicinity of the converging values, so that the vibrations are canceled to each other to suppress the disturbance of the output signal "f₃ + Δf".

As explained above, a local oscillation frequency is divided into first and second local oscillation frequencies in the PLL synthesizer units 1 and 2, so that a ratio between an oscillation frequency and a channel interval becomes small, and a division ratio of a frequency from the voltage controlled oscillator is lowered. Thus, a gain of the system is enhanced, and the change-over of frequencies is carried out with high speed.

In the invention, it is important that a time between the control signals a and b is set to cancel the vibrations of the carrier frequencies "f₁" and "f₂ + Δf" as shown in Fig. 4.

In the invention, a first and second carrier frequencies "f₁" and "f₂" may be converged to first and second increased or changed carrier frequencies "f₁ + Δf₁" and "f₂ + Δf₂", respectively, where the sum of increased components "Δf₁" and "Δf₂" is equal to the aforementioned change amount "Δf" (Δf = Δf₁ + Δf₂).

## Claims

1. A local oscillation frequency synthesizer, comprising:
first and second PLL synthesizers (1 and 2, respectively) for generating first and second frequency signals;
a signal coupler (3) for combining said first and second frequency signals to provide an output frequency signal; and
means (4) for controlling said first and second PLL synthesizers (1 and 2), characterized in that the controlling means (4) is adapted to change said first and second frequency signals by a frequency-change amount corresponding to a change-over of channels, the frequency of said first frequency signal being changed for a predetermined time period by said frequency-change amount, said first frequency signal being restored to its original frequency after being changed by said frequency-change amount, a frequency of said second frequency signal being changed by said frequency-change amount at a predetermined time after the frequency of said first frequency signal is changed by said frequency-change amount without restoring said second frequency signal to its original frequency.

2. A local oscillation frequency synthesizer, according to claim 1, wherein:
each of said first and second PLL synthesizer (1 and 2), comprises:
a reference frequency signal generator (15;16) for generating a reference frequency signal;
a voltage controlled oscillator (5;6) for generating a signal having a frequency which is dependent on a voltage applied thereto;
a frequency division circuit (11;12) for dividing said signal of said frequency supplied from said voltage controlled oscillator (5;6) by a predetermined division ratio;
a phase comparator (13;14) for comparing phases of said reference frequency signal and a divided signal supplied from said frequency division circuit to generate a phase difference signal;
a charge pump (9;10) for receiving said phase difference signal to generate a charge pump output signal; and
a loop filter (7;8) for receiving said charge pump output signal to apply said voltage of said charge pump output signal to said voltage controlled oscillator (5;6); and
said controlling means (4) controls said first and second PLL synthesizers (1 and 2), whereby said predetermined time for said second frequency signal is set, such that a lowest level in a vibration of said first frequency signal and a highest level in a vibration of said second frequency signal occur at the same time.

## Patentansprüche

1. Überlagerungsfrequenzsynthetisator mit:
einem ersten und einem zweiten PLL-Synthetisator (1 bzw. 2) zum Erzeugen eines ersten und eines zweiten Frequenzsignals;
einem Signalkoppler (3) zum Kombinieren des ersten und des zweiten Frequenzsignals, um ein Ausgangsfrequenzsignal zu erzeugen; und
einer Einrichtung (4) zum Steuern des ersten und des zweiten PLL-Synthetisators (1 und 2),
**dadurch gekennzeichnet, daß**
die Steuerungseinrichtung (4) dazu geeignet ist, das erste und das zweite Frequenzsignal um einen einer Kanalumschaltung entsprechenden Frequenzänderungswert zu ändern, wobei die Frequenz des ersten Frequenzsignals für eine vorgegebene Zeitdauer um den Frequenzänderungswert geändert wird, die ursprüngliche Frequenz des ersten Frequenzsignals wiederhergestellt wird, nachdem sie um den Frequenzänderungswert geändert wurde, und die Frequenz des zweiten Frequenzsignals zu einem vorgegebenen Zeitpunkt, nachdem die Frequenz des ersten Frequenzsignals um den Frequenzänderungswert geändert wurde, um den Frequenzänderungswert geändert wird, ohne daß die ursprüngliche Frequenz des zweiten Frequenzsignals wiederhergestellt wird.

2. Überlagerungsfrequenzsynthetisator nach Anspruch 1, wobei
der erste und der zweite PLL-Synthetisator (1 und 2) jeweils aufweisen:
einen Referenzfrequenzsignalgenerator (15; 16) zum Erzeugen eines Referenzfrequenzsignals;
einen spannungsgesteuerten Oszillator (5; 6) zum Erzeugen eines Signals mit einer Frequenz, die von einer ihm zugeführten Spannung abhängig ist;
eine Frequenzuntersetzungsschaltung (11; 12) zum Teilen der Frequenz des vom spannungsgesteuerten Oszillator (5; 6) zugeführten Signals gemäß einem bestimmten Untersetzungsverhältnis;
einen Phasenvergleicher (13; 14) zum Vergleichen von Phasen des Referenzfrequenzsignals und des von der Frequenzuntersetzungsschaltung zugeführten untersetzten Signals, um ein Phasendifferenzsignal zu erzeugen;
eine Ladungspumpe (9; 10) zum Empfangen des Phasendifferenzsignals, um ein Ladungspumpenausgangssignal zu erzeugen; und
ein Schleifenfilter (7; 8) zum Empfangen des Ladungspumpenausgangssignals, um die Spannung des Ladungspumpenausgangssignals dem spannungsgesteuerten Oszillator (5; 6) zuzuführen; wobei
die Steuerungseinrichtung (4) den ersten und den zweiten PLL-Synthetisator (1 und 2) steuert, wobei die vorgegebene Zeitdauer für das zweite Frequenzsignal so eingestellt ist, daß ein niedrigster Pegel einer Schwingung des ersten Frequenzsignals und ein höchster Pegel einer Schwingung des zweiten Frequenzsignals gleichzeitig auftreten.

## Revendications

1. Synthétiseur de fréquence produisant une oscillation locale, comprenant :
des premiers et second synthétiseurs à PLL (1 et 2, respectivement) destinés à générer des signaux ayant une première et une seconde fréquence;
un coupleur de signaux (3) destiné à combiner les signaux de première et seconde fréquence pour fournir un signal de fréquence de sortie; et
un moyen (4) destiné à commander lesdits premier et second synthétiseurs à PLL (1 et 2), caractérisé en ce que le moyen de commande (4) est adapté pour faire subir auxdits signaux de première et seconde fréquence un changement de fréquence d'une valeur correspondant à un changement de canaux, la fréquence dudit signal de première fréquence étant changée pendant une durée prédéterminée de ladite valeur de changement de fréquence, ledit signal de première fréquence étant ramené à sa fréquence originelle après avoir subi un changement de fréquence de ladite valeur, une fréquence dudit signal de seconde fréquence subissant un changement de fréquence de ladite valeur à un instant prédéterminé après que la fréquence dudit signal de première fréquence a subi un changement de fréquence de ladite valeur sans ramener ledit signal de seconde fréquence à sa fréquence originelle.

2. Synthétiseur de fréquence produisant un oscillation locale, selon la revendication 1, dans lequel :
chacun desdits premier et second synthétiseurs à PLL (1 et 2), comprend :
un générateur de signal de référence (15; 16) destiné à générer un signal de fréquence de référence;
un oscillateur (5; 6) commandé par tension générant une fréquence dépendant d'une tension qui lui est appliquée;
un circuit (11; 12) de division de fréquence destiné à diviser ledit signal de ladite fréquence fourni par ledit oscillateur (5; 6) commandé par tension par un rapport de division prédéterminé;
un comparateur de phase (13; 14) destiné à comparer les phases du signal de ladite fréquence et d'un signal divisé fourni par ledit circuit de division de fréquence pour générer un signal de différence de phase;
une pompe de charge (9; 10) destinée à recevoir ledit signal de différence de phase pour générer un signal de sortie de pompe de charge; et
un filtre en boucle (7; 8) destiné à recevoir ledit signal de sortie de pompe de charge pour appliquer ladite tension dudit signal de sortie de pompe de charge audit oscillateur (5; 6) commandé par tension; et
ledit moyen de commande (4) commande lesdits premier et second synthétiseurs à PLL (1 et 2), ledit instant prédéterminé pour ledit signal de seconde fréquence étant réglé de telle manière qu'un plus bas niveau dans une vibration dudit signal de première fréquence et un plus haut niveau dans une vibration dudit signal de seconde fréquence se produisent en même temps.
